(19) Europäisches Patentamt
European Patent Office
Office européen des brevets

(11) EP 4 722 814 A1

(12) **EUROPEAN PATENT APPLICATION**
published in accordance with Art. 153(4) EPC

(43) Date of publication:
**08.04.2026 Bulletin 2026/15**

(21) Application number: **24811127.0**

(22) Date of filing: **21.05.2024**

(51) International Patent Classification (IPC):
***G03F 7/32*** *(2006.01)* ***G03F 7/004*** *(2006.01)*
***G03F 7/20*** *(2006.01)*

(52) Cooperative Patent Classification (CPC):
**G03F 7/004; G03F 7/20; G03F 7/32**

(86) International application number:
**PCT/JP2024/018746**

(87) International publication number:
**WO 2024/242121 (28.11.2024 Gazette 2024/48)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **24.05.2023 JP 2023085571**

(71) Applicant: **TOKYO OHKA KOGYO CO., LTD.**
**Kawasaki-shi, Kanagawa 211 0012 (JP)**

(72) Inventors:
- **KUBO, Keisuke**
  **Kawasaki-shi, Kanagawa 211-0012 (JP)**
- **KIMURA, Kenta**
  **Kawasaki-shi, Kanagawa 211-0012 (JP)**
- **NAGATA, Masaya**
  **Kawasaki-shi, Kanagawa 211-0012 (JP)**
- **INARI, Takatoshi**
  **Kawasaki-shi, Kanagawa 211-0012 (JP)**

(74) Representative: **Plasseraud IP**
**104 Rue de Richelieu**
**CS92104**
**75080 Paris Cedex 02 (FR)**

# (54) PATTERN FORMING METHOD AND PROCESSING LIQUID FOR METAL COMPOUND-CONTAINING FILM

(57) A pattern forming method includes a step of exposing a metal compound-containing film and a step of processing the exposed metal compound-containing film using a processing liquid. The processing liquid contains an organic solvent. The organic solvent contains a first solvent for which ClogP ≤ 0.7 and ΔH + ΔP ≥ 16. The amount of the first solvent is 30% by mass or more relative to 100% by mass of the organic solvent.

EP 4 722 814 A1

## Description

### Technical Field

The present invention relates to a pattern forming method and processing liquid for metal compound-containing film.

### Background Art

The evolution of the design of semiconductor devices to meet the need for improved performance of semiconductor devices has been achieved by reducing processed dimensions on semiconductor substrates. Regarding the pace of such a technological advancement, it is said that the density of transistors in high-density integrated circuits doubles every two years, which is referred to as "Moore's Law." Indeed, the design and manufacture of semiconductor device chips have advanced such that billions of elements such as transistors and circuits are formed on a single chip.
The size of individual structures on a semiconductor device chip is approximately 22 nm or less and can be less than 10 nm in some cases. In the photolithographic process for forming these fine structures, ultraviolet light (UV) having a wavelength of 193 nm is typically used for exposure. However, the wavelength of the light is already much larger than the desired size of the pattern to be formed on the semiconductor substrate. This causes various problems. For example, achieving a pattern size smaller than the wavelength of light requires a complicated technique for increased resolution, such as multiple patterning. Accordingly, it is of great importance to develop a lithographic technology that uses ultra-short wavelength light, such as extreme ultraviolet radiation (EUV) having a wavelength of approximately 10 to 15 nm (e.g., 13.5 nm), or particle radiation, such as electron beams (EBs).
However, in a photolithographic process using EUV, it is challenging to apply chemically amplified organic resists because of absorption characteristics of resist compositions. Imparting sufficient etching resistance to a patterned resist film formed using an organic resist, furthermore, requires thickening the resist film. In that case, there is a problem of a high risk of pattern collapse due to a high aspect ratio of the patterned resist film. In view of such circumstances, there is a need for a method whereby a resist film can be formed that can be suitably patterned by lithography using EUV (extreme ultraviolet radiation) or electron beams and that exhibits good etching resistance even when formed as a thin film.
To address such a demand, metal compound-containing resists made using a tin compound or the like have been proposed (e.g., PTL 1 and 2.).

### Citation List

### Patent Literature

PTL 1: U.S. Patent No. 11392028
PTL 2: U.S. Patent Publication No. 2021/026241

### Summary of Invention

### Technical Problem

The present invention was made in light of such circumstances in the related art, and an object thereof is to provide a pattern forming method for a metal compound-containing film and a processing liquid that is suitable for use in pattern formation on a metal compound-containing film.

### Solution to Problem

As a result of intensive studies to solve the above problem, the inventors found that a metal compound-containing film can be patterned with selective reduction of unexposed portions by using a processing liquid containing an organic solvent, the organic solvent containing one or more first solvents, each of which satisfies (1) ClogP $\leq$ 0.7 and (2) $\Delta H + \Delta P \geq 16$, with the amount of the first solvents being 30% by mass or more relative to 100% by mass of the organic solvent, after exposure of the metal compound-containing film. Based on these findings, the inventors completed the present invention.
That is, the present invention relates to each of the following inventions.

[1] A pattern forming method including a step of exposing a metal compound-containing film and a step of processing

the exposed metal compound-containing film using a processing liquid, wherein

the processing liquid contains an organic solvent,
the organic solvent contains one or more first solvents for each of which ClogP ≤ 0.7 and ΔH + ΔP ≥ 16, and
an amount of the first solvents is 30% by mass or more relative to 100% by mass of the organic solvent.

[2] A pattern forming method including a step of forming a metal compound-containing film using a metal compound-containing film forming composition, a step of exposing the metal compound-containing film, and a step of processing the exposed metal compound-containing film using a processing liquid, wherein

the processing liquid contains an organic solvent,
the organic solvent contains one or more first solvents for each of which ClogP ≤ 0.7 and ΔH + ΔP ≥ 16, and
an amount of the first solvents is 30% by mass or more relative to 100% by mass of the organic solvent.

[3] The pattern forming method according to [1], wherein

the organic solvent further contains one or more second solvents different from the first solvents, and
an amount of the second solvents is 1% to 70% by mass relative to 100% by mass of the organic solvent.

[4] The pattern forming method according to [3], wherein
the second solvents are one or more organic solvents different from the first solvents and selected from the group consisting of alcohol-based solvents containing three or more carbon atoms, ester-based solvents containing three or fewer oxygen atoms, and ketone-based solvents that do not contain two or more oxygen atoms.
[5] The pattern forming method according to [3], wherein
the second solvents are one or more solvents for each of which ClogP > 0.7 and ΔH + ΔP ≤ 25 or, alternatively, ClogP ≥ 0.35 and ΔH + ΔP < 16.
[6] The pattern forming method according to [3], wherein
the second solvents are one or more solvents selected from the group consisting of propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, and diethylene glycol monobutyl ether (BDG).
[7] The pattern forming method according to [1], wherein the processing liquid further contains water.
[8] The pattern forming method according to [7], wherein an amount of the water is 1% to 75% by mass relative to 100% by mass of the processing liquid.
[9] The pattern forming method according to [1], wherein the metal compound-containing film is a metal compound-containing film containing a metal element of group 3 to group 7.
[10] The pattern forming method according to [1], wherein the metal compound is a polyoxometalate.
[11] The pattern forming method according to [10], wherein the polyoxometalate is a polyoxomolybdate, a polyoxotungstate, a polyoxovanadate, a polyoxoniobate, or a polyoxotantalate.
[12] The pattern forming method according to [10], wherein the polyoxometalate is an onium salt.
[13] The pattern forming method according to [12], wherein the onium salt is an ammonium salt, a sulfonium salt, or an iodonium salt.
[14] The pattern forming method according to [1], wherein the exposure step is a step of exposing the metal compound-containing film using EUV or an electron beam.
[15] A processing liquid for a metal compound-containing film,

the processing liquid containing an organic solvent, wherein
the organic solvent contains one or more first solvents for each of which ClogP ≤ 0.7 and ΔH + ΔP ≥ 16, and
an amount of the first solvents is 30% by mass or more relative to 100% by mass of the organic solvent.

[16] The processing liquid according to [15] for a metal compound-containing film, wherein

the organic solvent further contains one or more second solvents different from the first solvents, and
an amount of the second solvents is 1% to 70% by mass relative to 100% by mass of the organic solvent.

[17] The processing liquid according to [16] for a metal compound-containing film, wherein
the second solvents are one or more organic solvents different from the first solvents and selected from the group consisting of alcohol-based solvents containing three or more carbon atoms, ester-based solvents containing three or

fewer oxygen atoms, and ketone-based solvents that do not contain two or more oxygen atoms.

[18] The processing liquid according to [16] for a metal compound-containing film, wherein the second solvents are one or more solvents for each of which ClogP > 0.7 and $\Delta H + \Delta P \leq 25$ or, alternatively, ClogP $\geq 0.35$ and $\Delta H + \Delta P < 16$.

[19] The processing liquid according to [16] for a metal compound-containing film, wherein the second solvents are one or more solvents selected from the group consisting of propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, and diethylene glycol monobutyl ether (BDG).

[20] The processing liquid according to [15] for a metal compound-containing film, the processing liquid further containing water.

[21] The processing liquid according to any of [15] to [20] for a metal compound-containing film, wherein the processing liquid is a processing liquid for a polyoxometalate-containing film.

## Advantageous Effects of Invention

According to the present invention, a pattern forming method for a metal compound-containing film and a processing liquid suitable for use in pattern formation on a metal compound-containing film can be provided. With the processing liquid according to the present invention, furthermore, the film in unexposed portions of a metal compound-containing film can be selectively reduced. This makes the processing liquid suitable for use as a processing liquid for metal compound films, particularly a processing liquid for polyoxometalate-containing films.

## Description of Embodiments

Preferred embodiments of the present invention will be described in detail below. However, the present invention is not limited to the following embodiments.

[1. Pattern Forming Method]

A pattern forming method according to this embodiment includes a step of forming a metal compound-containing film on a substrate using a metal compound-containing film forming composition, a step of exposing the metal compound-containing film, and a step of processing the exposed metal compound-containing film using a processing liquid. The processing liquid contains an organic solvent, and the organic solvent contains one or more first solvents, each of which satisfies the conditions of (1) and (2) below. The amount of the first solvents is 30% by mass or more relative to 100% by mass of the organic solvent.

(1)

$$\text{ClogP} \leq 0.7$$

(2)

$$\Delta H + \Delta P \geq 16$$

[1-1. Metal Compound-Containing Film Forming Composition]

The metal compound-containing film forming composition according to this embodiment contains a metal compound. The metal compound is not particularly limited and can be, for example, a metal atom or metal ion of at least one metal element of group 3 to group 16 in the long-form periodic table, a metal oxide of such a metal atom or metal ion, or a compound containing a ligand that binds to such a metal atom, metal ion, or metal oxide via ionic bonding, coordinate bonding, or covalent bonding.

[1-1-1. Metal Compound]

<Metal Element>

The metal element contained in the metal compound can be at least one metal element of group 3 to group 16 in the long-form periodic table.

Examples of metal elements of group 3 to group 16 in the long-form periodic table include the metal elements of group 3, such as scandium (Sc), yttrium (Y), lanthanum (La), and cerium (Ce); the metal elements of group 4, such as titanium (Ti), zirconium (Zr), and hafnium (Hf); the metal elements of group 5, such as vanadium (V), niobium (Nb), and tantalum (Ta); the metal elements of group 6, such as chromium (Cr), molybdenum (Mo), and tungsten (W); the metal elements of group 7, such as manganese (Mn) and rhenium (Re); the metal elements of group 8, such as iron (Fe), ruthenium (Ru), and osmium (Os); the metal elements of group 9, such as cobalt (Co), rhodium (Rh), and iridium (Ir); the metal elements of group 10, such as nickel (Ni), palladium (Pd), and platinum (Pt); the metal elements of group 11, such as copper (Cu), silver (Ag), and gold (Au); the metal elements of group 12, such as zinc (Zn), cadmium (Cd), and mercury (Hg); the metal elements of group 13, such as aluminum (Al), gallium (Ga), indium (In), and thallium (Tl); the metal elements of group 14, such as germanium (Ge), tin (Sn), and lead (Pb); the metal elements of group 15, such as antimony (Sb) and bismuth (Bi); the metal elements of group 16, such as tellurium (Te); and the like.
The metal compound may contain one such metal element alone or may contain two or more in combination.
Among such metal elements, the metal elements in period 4 to period 6 of group 3 to group 16 are particularly preferred for use as metal elements contained in the metal compound.
A tin compound or the like, furthermore, is suitable for use as the metal compound. However, a tin compound can cause, for example, the problems of instrumental contamination by residue produced during coating work and of the toxicity of the tin compound itself.
Accordingly, among such metal elements as listed above, the metal elements of group 3 to group 7 are more preferred for use in the metal compound. The metal elements in period 4 to period 6 of group 3 to group 7 are even more preferred for use.

<Metal Oxide>

The metal oxide of a metal atom or metal ion of at least one metal element is not particularly limited; known and commonly used metal oxides can be employed.
The metal oxide can be, for example, scandium oxide ($Sc_2O_3$), yttrium oxide ($Y_2O_3$), titanium oxide ($TiO_2$), zirconium oxide ($ZrO_2$), hafnium oxide ($HfO_2$), vanadium oxide ($V_2O_5$), niobium oxide ($Nb_2O_5$), tantalum oxide ($Ta_2O_5$), chromium oxide ($CrO_3$), molybdenum oxide ($MoO_3$), tungsten oxide ($WO_3$), aluminum oxide ($Al_2O_3$), gallium oxide ($Ga_2O_3$), indium oxide ($In_2O_3$), germanium dioxide ($GaO_2$), tin oxide (SnO), antimony trioxide ($Sb_2O_3$), or the like.

(Polyoxometalate)

Moreover, a polyoxometalate is suitable for use as the metal oxide. A polyoxometalate is an anionic metal oxide cluster whose general formula is represented by $[M_xO_y]^{n-}$ (In the formula, x, y, and n are all natural numbers.). The metal atom M constituting the polyoxometalate is referred to as the poly atom, and examples include Mo (hexavalent or pentavalent), W (hexavalent or pentavalent), V (pentavalent), Nb (pentavalent), Ta (pentavalent), and the like. Polyoxometalates can be broadly classified into isopolyoxometalates, which are composed of the poly atom M and an oxoacid, and heteropolyoxometalates, which contain the poly atom M, oxygen, and another kind of atom X (Examples of heteroatoms X include $P^{5+}$, $Si^{4+}$, $Ge^{4+}$, $B^{3+}$, and the like.) ($[X_wM_xO_y]^{n-}$ (In the formula, w, x, y, and n are all natural numbers.)).
Examples of isopolyoxometalates include salts of isopolyoxomolybdic acids, isopolyoxotungstic acids, isopolyoxovanadic acids, isopolyoxoniobic acids, isopolyoxotantalic acids, and the like.
Examples of the isopolyoxomolybdic acids include $[MoO_4]^{2-}$, $[Mo_7O_{24}]^{6-}$, $[Mo_8O_{26}]^{4-}$, and the like. Examples of the isopolyoxotungstic acids include $[W_4O_{13}]^{2-}$, $[W_5O_{16}]^{2-}$, $[W_6O_{19}]^{2-}$, $[W_7O_{22}]^{2-}$, $[W_7O_{24}]^{6-}$, $[H_zW_{12}O_{40}]^{-(8-z)}$ (Note that z represents an integer of 1 to 4.), $[W_{10}O_{32}]^{4-}$, $[H_4W_{11}O_{38}]^{6-}$, $[H_7W_{11}O_{40}]^{7-}$, $[HW_5O_{19}]^{7-}$, $[H_3W_{11}O_{22}]^{5-}$, and the like. Examples of the isopolyoxovanadic acids include $[V_4O_{12}]^{4-}$, $[V_{10}O_{28}]^{6-}$, and the like, examples of the isopolyoxoniobic acids include $[Nb_6O_{19}]^{8-}$, $[Nb_{10}O_{28}]^{6-}$, and the like, and examples of the isopolyoxotantalic acids include $[Ta_6O_{19}]^{8-}$, $[Ta_8O_{21}]^{2-}$, and the like.
It should be understood that the isopolyoxomolybdic acids, isopolyoxotungstic acids, isopolyoxovanadic acids, isopolyoxoniobic acids, and isopolyoxotantalic acids include various isomers and the like.
Examples of heteropolyoxometalates include salts of heteropolyoxomolybdic acids, heteropolyoxotungstic acids, heteropolyoxovanadic acids, heteropolyoxoniobic acids, heteropolyoxotantalic acids, and the like.
Examples of the heteropolyoxomolybdic acids include phosphomolybdic acid, silicomolybdic acid, boromolybdic acid, phosphotungstomolybdic salt, cobaltomolybdic acid, arsenomolybdic acid, germanomolybdic acid, and the like. Examples of the heteropolyoxotungstic acids include phosphotungstic acid, silicotungstic acid, borotungstic acid, cobaltotungstic acid, arsenotungstic acid, germanotungstic acid, and the like. Examples of the heteropolyoxovanadic acids include phosphomolybdovanadic acid, phosphomolybdotungstomolybdic acid, boromolybdovanadic acid, boromolybdotungstovanadic acid, and the like.

It should be understood that the heteropolyoxomolybdic acids, heteropolyoxotungstic acids, heteropolyoxovanadic acids, and the like include the Keggin type, the Dawson type, the Anderson type, lacunary forms and isomers thereof, and the like.

The salt type of the polyoxometalate (isopolyoxometalate or heteropolyoxometalate) is not particularly limited; the polyoxometalate may be a salt with protons, an onium cation (Examples include organic onium cations, organic sulfonium cations, organic iodonium cations, organic quaternary ammonium cations, organic phosphonium cations, and the like.), an alkali metal ion, or the like. For the salt type of the polyoxometalate, it is preferred that the polyoxometalate be a salt with an onium cation for improved actinic ray sensitivity or radiation sensitivity and the resulting variations in solvent solubility between exposed portions and unexposed portions. Of these, it is more preferred that the polyoxometalate be a salt with an organic sulfonium cation, an organic iodonium cation, or an organic quaternary ammonium cation.

The organic sulfonium cation is not particularly limited; known and commonly used organic sulfonium cations can be employed. Examples of organic sulfonium cations include an organic sulfonium cation represented by formula (I).

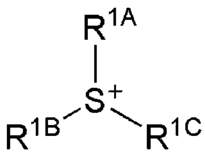

(I)

In formula (I), $R^{1A}$, $R^{1B}$, and $R^{1C}$ each independently represent a $C_{1-18}$ hydrocarbyl group, a 3- to 18-membered nonaromatic heterocyclic group, or a 5- to 18-membered aromatic heterocyclic group,

optionally with one or more divalent carbon atoms at any positions in $R^{1A}$, $R^{1B}$, and $R^{1C}$, excluding the terminal positions, replaced with -O-, -C(=O)-, -C(=O)O-, -OCO-, - CONH-, -NHCO-, -NH(C=O)O-, -S-, or $-SO_2-$ (Adjacent divalent carbon atoms, however, are not replaced simultaneously.);

each hydrogen atom included in $R^{1A}$, $R^{1B}$, and $R^{1C}$, furthermore, may be, for example, (a) a halogen atom, (b) a haloalkyl group, (c) a hydroxy group, (d) a thiol group, (e) a nitro group, (f) a cyano group, (g) a carboxyl group, (h) an amino group, (i) a sulfo group, (j) a hydroxy or carboxy group having a protecting group, or (k) a $C_{1-18}$ hydrocarbyl, $C_{1-18}$ hydrocarbyloxy, $C_{1-18}$ hydrocarbylcarbonyl, $C_{1-18}$ hydrocarbylcarbonyloxy, $C_{1-18}$ hydrocarbyloxycarbonyl, $C_{1-18}$ hydrocarbyloxycarbonyloxy, or $C_{1-18}$ hydrocarbylthio group optionally having at least a subset of hydrogen atoms replaced with (a) to (j) above, optionally with one or more divalent carbon atoms at any positions in the substituent, excluding the terminal positions, replaced with -O-, -C(=O)-, -C(=O)O-, -OCO-, -CONH-, -NHCO-, -NH(C=O)O-, -S-, or - $SO_2$- (Adjacent divalent carbon atoms, however, are not replaced simultaneously.); and,

in addition, any two of $R^{1A}$, $R^{1B}$, and $R^{1C}$ may be connected to each other, either directly via a single bond or with a divalent linking group -O-, -S-, -C(=O)-, -S(=O)-, - $S(=O)_2$-, -C(=O)O-, or $C_{1-3}$ alkylene interposed therebetween, forming a ring with the sulfur atom in formula (I).

It should be noted that in the present description, "hydroxy or carboxy group having a protecting group" means a hydroxy or carboxy group in which the hydroxy group (which may be a phenolic hydroxyl group) or carboxy group is protected by an ether-based protecting group, a silyl ether-based protecting group, an acyl-based protecting group, an aminocarbonyl-based protecting group, or the like.

Ether-based protecting groups are not particularly limited. Examples include a methyl group, a benzyl group, a p-methoxybenzyl group, a t-butyl group, a triphenylmethyl group, a p-methoxyphenyldiphenylmethyl group, a di(p-methoxyphenyl)phenylmethyl group, and the like.

Silyl ether-based protecting groups are not particularly limited. Examples include a t-butyldimethylsilyl group (TBS), a triisopropylsilyl group (TIPS), a trimethylsilyl group (TMS), a triethylsilyl group (TES), a t-butyldiphenylsilyl group (TBDPS), and the like.

Acyl-based protecting groups are not particularly limited. Examples include an acetyl group, a pivaloyl group, a benzoyl group, and the like.

Aminocarbonyl-based protecting groups are not particularly limited. Examples include a dimethylaminocarbonyl group, a diethylaminocarbonyl group, a diisopropylaminocarbonyl group, an N-phenyl-N-methyl-aminocarbonyl group, and the like.

Preferably, each of $R^{1A}$, $R^{1B}$, and $R^{1C}$ in formula (I) is independently an optionally substituted $C_{6-18}$ aryl group. A substituent in the $C_{6-18}$ aryl group is preferably a halogen atom, a haloalkyl group, a hydroxy group, a nitro group, a cyano group, an optionally substituted $C_{1-12}$ hydrocarbylthio group, more preferably a halogen atom, a $C_{1-4}$ haloalkyl group, or a nitro group.

Specific examples of the organic sulfonium cations include a dibutyl(pentyl)sulfonium cation, a triethylsulfonium cation, a (2-carboxyethyl)dimethylsulfonium cation, a trimethylsulfonium cation, a dimethylphenacylsulfonium cation, a

1-(4-hydroxynaphthalen-1-yl)hexahydrothiopyrylium cation, a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, an (ethan-1,2-diylbisoxy) bis(4,1-phenylene)bis(diphenylsulfonium) dication, a (thiodi-4,1-phenylene)bis(diphenylsulfonium) dication, a di(naphthalen-1-yl)(phenyl)sulfonium cation, a phenylbis(2-(trifluoromethyl)phenyl)sulfonium cation, a mesitylbis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl) sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation, a 5-(3-(trifluoromethyl)phenyl)-5H-dibenzo[b,d]thiophen-5-ium cation, a 1-(4-(t-butyl) phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl) methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a (2-bromoethyl)diphenylsulfonium cation, a dimesityl(trifluoromethyl)sulfonium cation, a tri-p-tolylsulfonium cation, and the like.

The organic iodonium cation is not particularly limited; known and commonly used organic iodonium cations can be employed. Examples of organic iodonium cations include an organic iodonium cation represented by formula (II).

$$R^{2A}-\overset{+}{I}-R^{2B} \quad \text{(II)}$$

In formula (II), $R^{2A}$ and $R^{2B}$ each independently represent a $C_{1-18}$ hydrocarbyl group, a 3- to 18-membered nonaromatic heterocyclic group, or a 5- to 18-membered aromatic heterocyclic group,

optionally with one or more divalent carbon atoms at any positions in $R^{2A}$ and $R^{2B}$, excluding the terminal positions, replaced with -O-, -C(=O)-, -C(=O)O-, -OCO-, -CONH-, -NHCO-, -NH(C=O)O-, -S-, or $-SO_2-$ (Adjacent divalent carbon atoms, however, are not replaced simultaneously.);

each hydrogen atom included in $R^{2A}$ and $R^{2B}$, furthermore, may be, for example, (a) a halogen atom, (b) a haloalkyl group, (c) a hydroxy group, (d) a thiol group, (e) a nitro group, (f) a cyano group, (g) a carboxyl group, (h) an amino group, (i) a sulfo group, (j) a hydroxy or carboxy group having a protecting group, or (k) a $C_{1-18}$ hydrocarbyl, $C_{1-18}$ hydrocarbyloxy, $C_{1-18}$ hydrocarbylcarbonyl, $C_{1-18}$ hydrocarbylcarbonyloxy, $C_{1-18}$ hydrocarbyloxycarbonyl, or $C_{1-18}$ hydrocarbyloxycarbonyloxy group optionally having at least a subset of hydrogen atoms replaced with (a) to (j) above, optionally with one or more divalent carbon atoms at any positions in the substituent, excluding the terminal positions, replaced with -O-, -C(=O)-, -C(=O)O-, -OCO-, -CONH-, -NHCO-, - NH(C=O)O-, -S-, or $-SO_2-$ (Adjacent divalent carbon atoms, however, are not replaced simultaneously.); and,

in addition, $R^{2A}$ and $R^{2B}$ may be connected to each other, either directly via a single bond or with a divalent linking group -O-, -S-, -C(=O)-, -S(=O)-, $-S(=O)_2-$, -C(=O)O-, or $C_{1-3}$ alkylene interposed therebetween, forming a ring with the iodine atom in formula (II).

Preferably, each of $R^{2A}$ and $R^{2B}$ in formula (II) is independently an optionally substituted $C_{6-18}$ aryl group. A substituent in the $C_{6-18}$ aryl group is preferably a halogen atom, a haloalkyl group, a hydroxy group, a nitro group, a cyano group, or an optionally substituted $C_{1-12}$ hydrocarbyl, $C_{1-12}$ hydrocarbyloxy, $C_{1-12}$ hydrocarbylcarbonyl, $C_{1-12}$ hydrocarbylcarbonyloxy, $C_{1-12}$ hydrocarbyloxycarbonyl, or $C_{1-12}$ hydrocarbyloxycarbonyloxy group, more preferably a halogen atom, a $C_{1-4}$ haloalkyl group, a nitro group, a $C_{1-8}$ hydrocarbyl group, or a $C_{1-8}$ hydrocarbyloxy group.

Specific examples of the iodonium cations include an ethynyl(phenyl)iodonium cation, a bis(pyridine)iodonium cation, a bis(2,4,6-trimethylpyridine)iodonium cation, a diphenyliodonium cation, a bis(4-(t-butyl)phenyl)iodonium cation, a (2-carboxyphenyl)(phenyl)iodonium cation, a (4-nitrophenyl)(phenyl)iodonium cation, a (3-(trifluoromethyl)phenyl) (2,4,6-trimethylphenyl)iodonium cation, a bis(4-fluorophenyl)iodonium cation, a (4-(bromomethyl)phenyl)(2,4,6-trimethoxyphenyl)iodonium cation, a 4-biphenylyl(2,4,6-trimethoxyphenyl)iodonium cation, a bis(2,4,6-trimethylphenyl) iodonium cation, a 4-isopropyl-4'-methyldiphenyliodonium cation, a (4-(trifluoromethyl)phenyl)(2,4,6-trimethylphenyl) iodonium cation, a ((4-trifluoromethyl)phenyl)(2,4,6-trimethoxyphenyl)iodonium cation, a (5-fluoro-2-nitrophenyl)(2,4,6-trimethoxyphenyl)iodonium cation, a (3-bromophenyl)(mesityl)iodonium cation, a bis(4-bromophenyl)iodonium cation, a (3,5-dichlorophenyl)(2,4,6-trimethoxyphenyl)iodonium cation, a (4-methylphenyl)(2,4,6-trimethylphenyl)iodonium cation, a (3-methylphenyl)(2,4,6-trimethylphenyl)iodonium cation, a (2-methylphenyl)(2,4,6-trimethylphenyl)iodonium cation, a phenyl(2,4,6-trimethoxyphenyl)iodonium cation, and the like.

The organic quaternary ammonium cation is not particularly limited; known and commonly used organic quaternary ammonium cations can be employed. Examples of organic quaternary ammonium cations include an organic quaternary ammonium cation represented by formula (III).

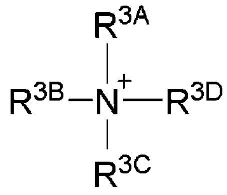

(III)

In formula (III), $R^{3A}$, $R^{3B}$, $R^{3C}$, and $R^{3D}$ each independently represent a $C_{1-18}$ hydrocarbyl group, a 3- to 18-membered nonaromatic heterocyclic group, or a 5- to 18-membered aromatic heterocyclic group,

optionally with one or more divalent carbon atoms at any positions in $R^{3A}$, $R^{3B}$ $R^{3C}$, and $R^{3D}$, excluding the terminal positions, replaced with -O-, -C(=O)-, -C(=O)O-, - OCO-, -CONH-, -NHCO-, -NH(C=O)O-, -S-, or $-SO_2-$ (Adjacent divalent carbon atoms, however, are not replaced simultaneously.);

each hydrogen atom included in $R^{3A}$, $R^{3B}$, $R^{3C}$, and $R^{3D}$, furthermore, may be, for example, (a) a halogen atom, (b) a haloalkyl group, (c) a hydroxy group, (d) a thiol group, (e) a nitro group, (f) a cyano group, (g) a carboxyl group, (h) an amino group, (i) a sulfo group, (j) a hydroxy or carboxy group having a protecting group, or (k) a $C_{1-18}$ hydrocarbyl, $C_{1-18}$ hydrocarbyloxy, $C_{1-18}$ hydrocarbylcarbonyl, $C_{1-18}$ hydrocarbylcarbonyloxy, $C_{1-18}$ hydrocarbyloxycarbonyl, $C_{1-18}$ hydrocarbyloxycarbonyloxy, or $C_{1-18}$ hydrocarbylthio group optionally having at least a subset of hydrogen atoms replaced with (a) to (j) above, optionally with one or more divalent carbon atoms at any positions in the substituent, excluding the terminal positions, replaced with -O-, -C(=O)-, -C(=O)O-, -OCO-, -CONH-, -NHCO-, -NH(C=O)O-, -S-, or - $SO_2$- (Adjacent divalent carbon atoms, however, are not replaced simultaneously.); and,

in addition, any two of $R^{3A}$ , $R^{3B}$, $R^{3C}$, and $R^{3D}$ may be connected to each other, either directly via a single bond or with a divalent linking group -O-, -S-, -C(=O)-, - S(=O)-, $-S(=O)_2-$, -C(=O)O-, or $C_{1-3}$ alkylene interposed therebetween, forming a ring with the nitrogen atom in formula (III).

Preferably, each of $R^{3A}$, $R^{3B}$, $R^{3C}$, and $R^{3D}$ in formula (III) is independently an optionally substituted $C_{1-18}$ hydrocarbyl group, more preferably a $C_{1-12}$ alkyl group, a $C_{1-12}$ alkenyl group, a $C_{1-12}$ alkynyl group, or a $C_{1-12}$ alicyclic group.

Specific examples of the organic quaternary ammonium cations include a tetramethylammonium cation, a tetraethylammonium cation, a tetrapropylammonium cation, a tetrabutylammonium cation, a tetraheptylammonium cation, a trimethylethylammonium cation, a dimethyldiethylammonium cation, a dimethylethylpropylammonium cation, a methylethylpropylbutylammonium cation, a trimethylphenylammonium cation, a triethylhexylammonium cation, a triethylcyclohexylammonium cation, a dodecyltrimethylammonium cation, and the like.

Polyoxometalates have features such as high thermal stability, oxidation resistance, high acid strength and oxidizing power, and reversible multi-electron redox capability, and cases of synthesis and use of actinic ray-sensitive or radiation-sensitive polyoxometalates have been reported so far (e.g., Japanese Unexamined Patent Application Publication No. 63-113452, Japanese Patent Application No. 59-154089, Japanese Patent Application No. 58-180400, and the like). However, polyoxometalates exhibit poor solubility in solvents because they are salts of anionic multinuclear metal-oxo clusters. With polyoxometalates, furthermore, it has been difficult to create a difference in solubility between portions exposed to actinic rays or radiation and unexposed portions.

However, with the processing liquid according to this embodiment, which will be described later, a pattern can be suitably formed even when the metal compound-containing film forming composition contains a polyoxometalate as the metal compound.

In the metal compound-containing film forming composition according to this embodiment, the amount of the metal compound is not particularly limited and can be selected as appropriate according to factors such as the type and intended use of the metal compound. The amount of the metal compound in the metal compound-containing film forming composition is preferably 0.5% to 20% by mass when it is assumed that the amount of the metal compound-containing film forming composition is 100% by mass. More preferably, the composition contains the metal compound at a concentration of 1% to 20% by mass, even more preferably 1% to 10% by mass.

[1-1-2. Others]

The metal compound-containing film forming composition may optionally contain components such as at least one organic solvent, an inorganic filler, a quencher, a leveling agent, and a surfactant.

The organic solvent is not particularly limited, as long as it dissolves the metal compound, thereby allowing the metal compound-containing film to be formed on the substrate.

Examples of organic solvents include halogenated hydrocarbons, such as dichloromethane and 1,2-dichloroethane; alcohols, such as methanol, ethanol, isopropanol, tert-butanol, 2-methyl-2-butanol, 4-methyl-2-pentanol, and diacetone alcohol, ethers, such as propylene glycol monomethyl ether (PGME), diethyl ether, tetrahydrofuran, and 1,4-dioxane; ketones, such as acetone, methyl ethyl ketone, methyl isobutyl ketone, 2-heptanone, and cyclohexanone; esters, such as ethyl acetate, n-butyl acetate, propylene glycol monomethyl ether acetate (PGMEA), ethyl lactate (EL), hydroxyisobutyrate methyl ester, and ethyl acetoacetate; lactones, such as γ-butyrolactone (GBL) and ε-caprolactone; lactams, such as N-methylpyrrolidone, nitriles, such as acetonitrile and propionitrile; cyclic or acyclic carbonates, such as dimethyl carbonate, ethylene carbonate, propylene carbonate, and diphenyl carbonate; polar aprotic solvents, such as dimethyl sulfoxide and dimethylformamide; water; and the like.

One such organic solvent may be used alone, or two or more may be used in combination.

The organic solvent contained in the metal compound-containing film forming composition according to this embodiment is preferably propylene glycol mono methyl ether(PGME), propylene glycol mono methyl ether acetate(PGMEA), ethyl lactate(EL), γ -butyrolactone(GBL), methanol, water, or a combination thereof.

[1-2. Metal Compound-Containing Film Forming Step]

The pattern forming method according to this embodiment includes a step of forming a metal compound-containing film on a substrate using the metal compound-containing film forming composition.

<Substrate>

The substrate used in this embodiment is not particularly limited; known and commonly used substrates can be employed. For example, a substrate for an electronic component, a substrate having a predetermined wiring pattern formed thereon, or the like may be used.

The material for the substrate is not particularly limited. Examples include a silicon wafer, substrates made of copper, chromium, iron, aluminum, or other metals, substrates formed from glass, titanium oxide, silicon dioxide, or other inorganic substances, and the like.

The size, shape, and other characteristics of the substrate are not particularly limited. The surface of the substrate may be smooth or may be curved or textured. The substrate may be a thin film-shaped substrate or the like.

The surface of the substrate may optionally have undergone surface treatment. In the case of a substrate having hydroxyl groups on the surface layer of the substrate, surface treatment of the substrate can be performed using a silane-based coupling agent capable of reacting with hydroxyl groups to alter the surface layer of the substrate from hydrophilic to hydrophobic, thereby improving adhesion between the substrate and the metal compound-containing film. Examples of the silane-based coupling agent include hexamethyldisilazane (HMDS) and the like.

<Film Forming Method>

The method for forming the metal compound-containing film on the substrate is not particularly limited; known and commonly used methods can be employed. For dry techniques, examples of film forming methods that can be used include CVD (chemical vapor deposition), such as thermal CVD, plasma CVD, and photo-CVD; PVD (physical vapor deposition), such as vacuum deposition, plasma-assisted deposition, sputtering, and ion plating; and the like. As for wet techniques, examples of methods that can be used include spin coating, bar coating, roll coating, flow coating, dip coating, spray coating, screen printing, and other coating techniques and the like.

The method for forming the metal compound-containing film on the substrate using the metal compound-containing film forming composition according to this embodiment is preferably a wet technique, such as spin coating or screen printing, so that the film is formed uniformly, for example in terms of thickness. More preferably, spin coating is used.

The method for drying the metal compound-containing film after forming it on the substrate is not particularly limited. For example, drying can be performed using a hot plate or another heating device (post-apply bake (PAB)), a pressure-reducing device, or the like.

The baking conditions are not particularly limited and can be set as appropriate according to factors such as the type and intended use of the metal compound-containing film. The baking temperature is preferably 100°C to 300°C, more preferably 150°C to 250°C, even more preferably 170°C to 230°C. The baking duration, furthermore, is preferably 10 to 300 seconds, more preferably 20 to 180 seconds, even more preferably 30 to 120 seconds.

The thickness of the metal compound-containing film after drying is not particularly limited, but preferably is 0.5 to 100 nm, more preferably 1 to 75 nm, even more preferably 1 to 60 nm.

[1-3. Step of Exposing the Metal Compound-Containing Film]

The pattern forming method according to this embodiment includes a step of exposing the metal compound-containing film that has been formed.

In the step of exposing the metal compound-containing film, the exposure device used can be an ArF exposure device, an electron beam drawing device, an EUV exposure device, or the like. In the exposure step, furthermore, exposure may be performed using a mask having a predetermined pattern formed thereon (a mask pattern). Alternatively, selective exposure may be formed without using a mask pattern, for example through drawing by direct irradiation with electron beams.

The wavelength used for exposure is not particularly limited. An ArF excimer laser (wavelength, 193 nm), a KrF excimer laser (248 nm), an $F_2$ excimer laser (wavelength, 157 nm), or radiation, such as EUV (extreme ultraviolet radiation), VUV (vacuum ultraviolet radiation), EBs (electron beams), X-rays, or soft X-rays, may be used.

The amount of exposure of the metal compound-containing film is preferably 1 to 100 mJ/cm$^2$, more preferably 20 to 60 mJ/cm$^2$, in the case of an ArF excimer laser or KrF excimer laser.

In the case of extreme ultraviolet radiation, furthermore, the amount of exposure is preferably 0.1 to 20 mJ/cm$^2$, more preferably 3 to 15 mJ/cm$^2$.

In the case of electron beams, it is preferred to expose the film with a dose of 3 $\mu$C/cm$^2$ to 2 mC/cm$^2$ at 50 kV. Preferably, the film is exposed with a dose of 10 $\mu$C/cm$^2$ to 1.5 mC/cm$^2$.

After exposure of the metal compound-containing film, baking (post-exposure bake (PEB)) treatment may be performed. The baking conditions are not particularly limited and can be set as appropriate according to factors such as the type and intended use of the metal compound-containing film. The baking temperature is preferably 120°C to 300°C, using a hot plate or another heating device. More preferably, the baking temperature is 150°C to 250°C, even more preferably 170°C to 230°C. The baking duration, furthermore, is preferably 10 to 300 seconds, more preferably 20 to 180 seconds, even more preferably 30 to 120 seconds.

[1-4. Step of Processing Using a Processing Liquid]

The pattern forming method according to this embodiment includes a step of processing the exposed metal compound-containing film using a processing liquid.

<Processing Liquid>

The processing liquid according to this embodiment contains an organic solvent. The amount of the organic solvent contained in the processing liquid is not particularly limited and can be set as appropriate according to factors such as the type of the organic solvent and the type of the intended metal compound-containing film. For the amount of the organic solvent contained in the processing liquid, it is preferred that the organic solvent be contained at a concentration of 25% to 100% by mass relative to 100% by mass of the processing liquid. More preferably, the organic solvent is contained at a concentration of 30% to 100% by mass, even more preferably 30% to 90% by mass.

The organic solvent contains one or more first solvents, each of which satisfies the conditions of (1) to (2) below.

(1)

$$\mathrm{ClogP} \leq 0.7$$

(2)

$$\Delta\mathrm{H} + \Delta\mathrm{P} \geq 16$$

(ClogP)

In this context, the ClogP value is the value of the common logarithm logP of the 1-octanol/water partition coefficient P determined by calculation. The method and software used to calculate the ClogP value can be a known and commonly used method and software. In the present description, values of ClogP calculated using DataWarrior V5.5.0 (www.openmolecules.org) are used.

Although not particularly limited, examples of solvents having a ClogP value of 0.7 or less include dimethylformamide (DMF) (ClogP value = -0.45), dimethylacetamide (ClogP value = -0.0789), methanol (MeOH) (ClogP value = -0.36), ethanol (EtOH) (ClogP value = 0.05), 3-methoxy-1-butanol (ClogP value = 0.37), 1-methoxy-2-propanol (PE or PGME) (ClogP value = -0.09), propylene glycol monomethyl ether acetate (PGMEA) (ClogP value = 0.40), acetylacetone (ClogP value = 0.23), hydroxyacetone (ClogP value = -0.55), 4-hydroxy-2-butanone (ClogP value = -0.09), diacetone alcohol (ClogP value = 0.65), methyl 2-hydroxyisobutyrate (ClogP value = -0.06), N-methyl-2-pyrrolidone (ClogP value =

0.09), ethyl lactate (EL) (ClogP value = -0.03), methyl methoxypropionate (ClogP value = 0.08), γ-butyrolactone (ClogP value = -0.02), isopropanol (ClogP value = 0.41), dimethyl sulfoxide (ClogP value = -1.28), diethylene glycol (ClogP value, -0.97), ethylene glycol (ClogP value = -0.88), dipropylene glycol (ClogP value = -0.06), propylene glycol (ClogP value = -0.52), γ-butyrolactone (ClogP value = -0.02), and the like.

One such solvent may be used alone, or two or more may be used in combination.

(ΔH + ΔP)

Hansen solubility parameters are three divided components of the solubility of a material, namely the dispersion term ΔD, the polarity term ΔP, and the hydrogen bonding term ΔH, expressed in a three-dimensional space. In this context, the dispersion term ΔD indicates the effect of dispersion forces, the polarity term ΔP indicates the effect of dipolar intermolecular forces, and the hydrogen bonding term ΔH indicates the effect of hydrogen bonding.

Hansen solubility parameters can be calculated using a known and commonly used method and software. In the present description, values of ΔH and ΔP as estimated values calculated using Hansen Solubility Parameters in Practice (HSPiP) 5th edition 5.4.02 are used.

Although not particularly limited, examples of solvents having a ΔH + ΔP value of 16 ($MPa^{1/2}$) or greater include DMF (ΔH + ΔP = 25), MeOH (ΔH + ΔP = 34.6), EtOH (ΔH + ΔP = 26.5), t-butanol (t-BuOH) (ΔH + ΔP = 20.2), 3-methoxy-1-butanol (ΔH + ΔP = 18.6), 3-methoxy-3-methyl-1-butanol (ΔH + ΔP = 16.8), PE or PGME (ΔH + ΔP = 20), acetylacetone (ΔH + ΔP = 17.8), hydroxyacetone (ΔH + ΔP = 29.3), 4-hydroxy-2-butanone (ΔH + ΔP = 25.8), diacetone alcohol (ΔH + ΔP = 18.6), methyl 2-hydroxyisobutyrate (ΔH + ΔP = 19.7), ethylene glycol (ΔH + ΔP = 40.9), and the like. In addition to these, solvents such as dimethylacetamide (ΔH + ΔP = 21.8), N-methyl-2-pyrrolidone (ΔH + ΔP = 19.5), dimethyl sulfoxide (ΔH + ΔP = 22.7), and γ-butyrolactone (ΔH + ΔP = 23.3) may be used.

One such solvent may be used alone, or two or more may be used in combination.

(First Solvent(s))

In the organic solvent contained in the processing liquid according to this embodiment, one or more first solvents for each of which (1) ClogP ≤ 0.7 and (2) ΔH + ΔP ≥ 16 are contained. For the amount of the first solvents contained in the organic solvent, it is preferred that the first solvents be contained at a concentration of 30% by mass or more relative to 100% by mass of the organic solvent. More preferably, the first solvents are contained at a concentration of 30% to 90% by mass, even more preferably 40% to 80% by mass.

Examples of first solvents, which satisfy the conditions of (1) and (2) above, include, but are not limited to, DMF, MeOH, EtOH, isopropyl alcohol, n-butyl alcohol, sec-butyl alcohol, isobutyl alcohol, 3-methoxy-1-butanol, PE or PGME, acetylacetone, hydroxyacetone, 4-hydroxy-2-butanone, diacetone alcohol, methyl 2-hydroxyisobutyrate, ethyl lactate (EL), γ-butyrolactone, acetonitrile, dimethylacetamide, dimethyl sulfoxide, ethylene glycol, and the like.

One such solvent may be used alone, or two or more may be used in combination.

(Second Solvent(s))

The organic solvent contained in the processing liquid according to this embodiment may contain one or more second solvents different from the first solvents. The amount of the second solvents contained in the organic solvent is not particularly limited. For selective reduction of the film in unexposed portions, it is preferred that the second solvents be contained at a concentration of 1% to 70% by mass relative to 100% by mass of the organic solvent. More preferably, the second solvents are contained at a concentration of 10% to 70% by mass, even more preferably 20% to 60% by mass.

Solvents that can be used as second solvents include alcohol-based solvents, amide-based solvents, ester-based solvents, ether-based solvents, ketone-based solvents, hydrocarbon-based solvents, and the like, excluding organic solvents included as first solvents.

Examples of alcohol-based solvents include alcohols, such as tert-butyl alcohol, n-hexyl alcohol, n-heptyl alcohol, n-octanol, and 4-methyl-2-pentanol (MIBC); glycols, such as triethylene glycol; glycol ethers having a hydroxyl group, such as propylene glycol monomethyl ether, diethylene glycol monomethyl ether, triethylene glycol monoethyl ether, methoxymethylbutanol, ethylene glycol monopropyl ether, ethylene glycol monobutyl ether, propylene glycol monoethyl ether, propylene glycol monopropyl ether, and propylene glycol monobutyl ether; and the like.

Examples of amide-based solvents include N-methyl-2-pyrrolidone and the like.

Examples of ester-based solvents include butyl acetate, ethyl acetate, isopropyl acetate, amyl acetate, isoamyl acetate, butyl lactate, dibutyl carbonate, propylene glycol monomethyl ether acetate (PGMEA), ethylene glycol monoethyl ether acetate, ethylene glycol monopropyl ether acetate, ethylene glycol monobutyl ether acetate, diethylene glycol monomethyl ether acetate, diethylene glycol monopropyl ether acetate, diethylene glycol monoethyl ether acetate, diethylene glycol monoethyl ether acetate, 2-methoxybutyl acetate, 3-methoxybutyl acetate, 4-methoxybutyl acetate, and

the like.

Examples of ether-based solvents include propylene glycol dimethyl ether, propylene glycol diethyl ether, diethylene glycol dimethyl ether, diethylene glycol diethyl ether, tetrahydrofuran, anisole, and the like.

Examples of ketone-based solvents include 1-hexanone, 2-hexanone, 1-heptanone, 2-heptanone, diisobutyl ketone, cyclohexanone, cycloheptanone, methyl isobutyl ketone (MIBK), and the like.

Examples of hydrocarbon-based solvents include butane, pentane, hexane, heptane, octane, nonane, decane, undecane, dodecane, and the like.

One such solvent may be used alone, or two or more may be used in combination.

An alcohol-based solvent used as a second solvent is preferably an alcohol-based solvent that contains three or more carbon atoms, such as tert-butyl alcohol, n-hexyl alcohol, n-heptyl alcohol, octanol, 4-methyl-2-pentanol (MIBC) or the like. More preferably, the alcohol-based solvent is an alcohol-based solvent containing three to twelve carbon atoms.

An ester-based solvent used as a second solvent, furthermore, is preferably an ester-based solvent that contains three or fewer oxygen atoms, such as butyl acetate, butyl lactate, propylene glycol monomethyl ether acetate (PGMEA), ethylene glycol monoethyl ether acetate, ethylene glycol monopropyl ether acetate, 2-methoxybutyl acetate, 3-methoxybutyl acetate, 4-methoxybutyl acetate, or the like.

Moreover, a ketone-based solvent used as a second solvent is preferably a ketone-based solvent that does not contain two or more oxygen atoms, such as 1-hexanone, 2-hexanone, 1-heptanone, 2-heptanone, diisobutyl ketone, cyclohexanone, cycloheptanone, methyl isobutyl ketone (MIBK), or the like.

The second solvents, furthermore, are preferably one or more organic solvents for each of which (3) $\mathrm{ClogP} > 0.7$ and (4) $\Delta H + \Delta P \leq 25$ or, alternatively, (5) $\mathrm{ClogP} \geq 0.35$ and (6) $\Delta H + \Delta P < 16$.

Examples of second solvents that satisfy (3) and (4) above or (5) and (6) above include, but are not limited to, propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, diethylene glycol monobutyl ether (BDG), and the like.

One such solvent may be used alone, or two or more may be used in combination.

That is, the second solvents are preferably one or more organic solvents different from the first solvents and selected from the group consisting of alcohol-based solvents, ester-based solvents, and ketone-based solvents. Then, more preferably, the second solvents are one or more solvents different from the first solvents and selected from the group consisting of alcohol-based solvents containing three or more carbon atoms, ester-based solvents containing three or fewer oxygen atoms, and ketone-based solvents that do not contain two or more oxygen atoms. In addition, even more preferably, the second solvents are one or more solvents for each of which (3) $\mathrm{ClogP} > 0.7$ and (4) $\Delta H + \Delta P \leq 25$ or, alternatively, (5) $\mathrm{ClogP} \geq 0.35$ and (6) $\Delta H + \Delta P < 16$. Particularly preferably, the second solvents are one or more organic solvents selected from the group consisting of propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, and diethylene glycol monobutyl ether (BDG).

(Water)

The processing liquid according to this embodiment may further contain water. Water itself is a poor solvent for metal compound-containing films. However, by incorporating water in the processing liquid, the performance of the formed pattern can be improved, compared with when a processing liquid consisting solely of the organic solvent is used.

The amount of water in the processing liquid is not particularly limited. Preferably, water is contained at a concentration of 1% to 75% by mass when it is assumed that the amount of the processing liquid is 100% by mass. More preferably, water is contained at a concentration of 10% to 70% by mass, even more preferably 20% to 60% by mass.

(Applications of the Processing Liquid)

This processing liquid is suitable for use as a developer for developing the metal compound-containing film after the exposure step, and also as a rinsing liquid for rinsing the developed metal compound-containing film. In particular, the processing liquid according to this embodiment exhibits a difference in solubility between exposed portions and unexposed portions of metal compound-containing films, allowing for a contrast between the exposed portions and the unexposed portions.

The processing liquid, therefore, is suitable for use as a negative developer with which a metal compound-containing film is developed after exposure of the metal compound-containing film using an ArF excimer laser (wavelength, 193 nm), a KrF excimer laser (248 nm), an $F_2$ excimer laser (wavelength, 157 nm), EUV (extreme ultraviolet radiation), VUV (vacuum ultraviolet radiation), EBs (electron beams), X-rays, or the like. That is, unexposed portions of the metal compound-containing film are selectively dissolved and removed by the processing liquid, allowing a metal compound-containing film pattern to be formed.

<Processing Step>

The pattern forming method according to this embodiment includes a step of processing the exposed metal compound-containing film using the processing liquid.

The method for developing the metal compound-containing film using the processing liquid as a developer is not particularly limited; known and commonly used methods can be employed. Examples of methods for developing the film using the processing liquid described above include the method of immersing a substrate including the exposed metal compound-containing film in the processing liquid for a certain period of time (dipping), the method of spraying the processing liquid onto the surface of the exposed metal compound-containing film (spraying), the method of dispensing the processing liquid at a constant rate from a dispensing nozzle onto the surface of the exposed metal compound-containing film on a substrate rotating at a constant rate (dynamic dispensing), and the like.

The method for washing the developed metal compound-containing film pattern using the processing liquid as a rinsing liquid, furthermore, is not particularly limited; known and commonly used methods can be employed. Examples of methods for rinsing the pattern using the processing liquid described above include the method of immersing a substrate including the metal compound-containing film pattern in the processing liquid for a certain period of time (dipping), the method of spraying the processing liquid onto the surface of the metal compound-containing film pattern (spraying), the method of dispensing the processing liquid at a constant rate from a dispensing nozzle onto the surface of the metal compound-containing film pattern on a substrate rotating at a constant rate (rotary coating), and the like.

[2. Processing Liquid for Metal Compound-Containing Films]

A processing liquid according to this embodiment for metal compound-containing films contains an organic solvent. The amount of the organic solvent contained in the processing liquid for metal compound-containing films is not particularly limited and can be set as appropriate according to factors such as the type of the organic solvent and the type of the intended metal compound-containing film. For the amount of the organic solvent contained in the processing liquid for metal compound-containing films, it is preferred that the organic solvent be contained at a concentration of 25% to 100% by mass relative to 100% by mass of the processing liquid for metal compound-containing films. More preferably, the organic solvent is contained at a concentration of 30% to 100% by mass, even more preferably 30% to 90% by mass.

The processing liquid according to this embodiment for metal compound-containing films contains one or more first solvents for each of which ClogP $\leq 0.7$ and $\Delta H + \Delta P \geq 16$ in the organic solvent at a concentration of 30% by mass or more when it is assumed that the amount of the organic solvent is 100% by mass.

In the organic solvent in a processing liquid according to another embodiment for metal compound-containing films, one or more second solvents different from the first solvents may additionally be contained at a concentration of 1% to 70% by mass relative to 100% by mass of the organic solvent. For the amount of the second solvents contained in the organic solvent, it is preferred that the second solvents be contained at a concentration of 1% to 70% by mass relative to 100% by mass of the organic solvent for selective reduction of the film in unexposed portions. More preferably, the second solvents are contained at a concentration of 10% to 70% by mass, even more preferably 20% to 60% by mass.

The second solvents are preferably one or more solvents different from the first solvents and selected from the group consisting of alcohol-based solvents, ester-based solvents, and ketone-based solvents. Then, more preferably, the second solvents are one or more solvents different from the first solvents and selected from the group consisting of alcohol-based solvents containing three or more carbon atoms, ester-based solvents containing three or fewer oxygen atoms, and ketone-based solvents that do not contain two or more oxygen atoms. In addition, even more preferably, the second solvents are one or more solvents for each of which (3) ClogP $> 0.7$ and (4) $\Delta H + \Delta P \leq 25$ or, alternatively, (5) ClogP $\geq 0.35$ and (6) $\Delta H + \Delta P < 16$. Still more preferably, the second solvents are one or more solvents selected from the group consisting of propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, and diethylene glycol monobutyl ether (BDG).

In a processing liquid according to yet another embodiment for metal compound-containing films, water may be contained in addition to the organic solvent. For the amount of water contained in the processing liquid for metal compound-containing films, it is preferred that water be contained at a concentration of 1% to 75% by mass relative to 100% by mass of the processing liquid for metal compound-containing films. More preferably, water is contained at a concentration of 10% to 70% by mass, even more preferably 20% to 60% by mass.

With the processing liquid according to this embodiment for metal compound-containing films, a pattern can be suitably formed even when the metal compound-containing film contains a polyoxometalate as the metal compound. The processing liquid, therefore, is suitable for use as a processing liquid for polyoxometalate-containing films.

## EXAMPLES

The present invention will be more specifically described below with reference to examples, but the present invention is not limited to these examples.

[1. Preparation of Test Metal Compound-Containing Film Forming Composition F]

Hexakis(bis(2-trifluoromethylphenyl)phenylsulfonium) metatungstate as a metal compound (metal compound M) and dimethylformamide (DMF) and ethyl lactate (EL) as solvents were blended such that the amount of each component was the amount specified in Table 1 (unit: parts by mass), and mixed using a stirrer. In this manner, test metal compound-containing film forming composition F was prepared.

[Table 1]

| | Metal Compound M | Solvent 1 (DMF) | Solvent 2 (EL) |
|---|---|---|---|
| Test metal compound-containing film forming composition F | 3 | 10 | 90 |

<Synthesis of Metal Compound M>

Metal compound M was synthesized by the method described below, and this compound was used to prepare test metal compound-containing film forming composition F.

In 99.36 g of purified water, 6.68 g of bis(2-trifluoromethylphenyl)phenylsulfonium chloride was dissolved. After addition of 6.88 g of ammonium metatungstate (ammonium metatungstate hydrate ($(NH_4)_6[H_2W_{12}O_{40}]\cdot xH_2O$)), the reaction liquid was stirred for 30 minutes at room temperature. A powdery substance obtained by filtering the reaction liquid was dried under reduced pressure at room temperature for 18 hours. After the dried powder was dissolved in 100 g of dimethylformamide, crystallization was induced at room temperature by adding 335 g of methanol. In this manner, metal compound M was obtained.

[2. Production of Test Film]

<Film Forming Step>

Test metal compound-containing film forming composition F was applied onto a hexamethyldisilazane (HDMS)-treated 8-inch silicon substrate using a spinner, and the applied coating was dried by performing a post-apply bake (PAB) treatment for 60 seconds at a temperature of 200°C on a hot plate. In this manner, a test metal compound-containing film having a thickness of 50 nm was formed. It should be noted that the average thickness of the formed metal compound-containing film was measured using a film thickness measuring device ("M-2000D," manufactured by the J.A. Woollam Company).

<Exposure Step>

This test metal compound-containing film was subjected to exposure by open-frame exposure using a KrF exposure device ("NSR-S203B," manufactured by NIKON CORPORATION; NA (numerical aperture) = 0.68; $\sigma$ = 0.75), with exposure conditions varied between portions with an amount of exposure of 50 mJ/cm$^2$ and unexposed portions.

After exposure, a post-exposure bake (PEB) treatment was performed for 60 seconds at 180°C. In this manner, a test film was produced.

[3. Study and Evaluation of Processing Liquids (single solvents)]

The above test film was developed for 60 seconds at 23°C using processing liquids A-1 to A-24 specified in Table 2 below, and then rinsed for 15 seconds at 23°C using 2-propanol. Thereafter, the changes in thickness in the exposed portions and the unexposed portions were measured using a film thickness measuring device.

<Film Reduction in Unexposed Portions>

Focusing on the change in thickness in the unexposed portions of the test film before and after development, film reduction in unexposed portions (= ((film thickness before development - film thickness after development) / film thickness

before development) × 100 (%)) was calculated. Then the developability of each processing liquid was evaluated according to the grading criteria below. The results are presented in Table 2.

A (excellent): The film reduction in unexposed portions is 80% or more and 100% or less

B (good): The film reduction in unexposed portions is 40% or more and less than 80%

C (poor): The film reduction in unexposed portions is less than 40%

[Table 2]

| | Processing liquid | Solvent | | Parameters | | Evaluation | |
|---|---|---|---|---|---|---|---|
| | | Name | Percentage | ClogP | ΔH+ΔP | Film reduction in unexposed portions (%) | Grade |
| Example 1-1 | A-1 | DMF | 100 | -0.45 | 25 | 100% | A |
| Example 1-2 | A-2 | MeOH | 100 | -0.36 | 34.6 | 100% | A |
| Example 1-3 | A-3 | EtOH | 100 | 0.05 | 28.2 | 55% | B |
| Example 1-4 | A-4 | 3-Methoxy-1-butanol | 100 | 0.37 | 19 | 87% | A |
| Example 1-5 | A-5 | PGME | 100 | -0.09 | 17.9 | 99% | A |
| Example 1-6 | A-6 | Acetylacetone | 100 | 0.23 | 16.2 | 100% | A |
| Example 1-7 | A-7 | Hydroxyacetone | 100 | -0.55 | 29.3 | 100% | A |
| Example 1-8 | A-8 | 4-Hydroxy-2-butanone | 100 | -0.09 | 25.8 | 97% | A |
| Example 1-9 | A-9 | Diacetone alcohol | 100 | 0.65 | 19 | 100% | A |
| Example 1-10 | A-10 | Methyl 2-hydroxyisobutyrate | 100 | -0.06 | 19.7 | 46% | B |
| Example 1-11 | A-11 | Ethyl lactate (EL) | 100 | -0.03 | 20.8 | 100% | A |
| Example 1-12 | A-12 | γ-Butyrolactone | 100 | -0.02 | 23.3 | 100% | A |
| Example 1-13 | A-13 | Acetonitrile | 100 | 0.22 | 24.9 | 100% | A |
| Comparative Example 1-1 | A-14 | t-BuOH | 100 | 0.79 | 19.8 | 2% | C |
| Comparative Example 1-2 | A-15 | MIBC | 100 | 1.54 | 15.6 | 2% | C |
| Comparative Example 1-3 | A-16 | 3-Methoxy-3-methyl-1-butanol | 100 | 0.75 | 19.2 | 3% | C |
| Comparative Example 1-4 | A-17 | MIBK | 100 | 10.2 | 1.51 | 9% | C |
| Comparative Example 1-5 | A-18 | PGMEA | 100 | 0.40 | 15.4 | 4% | C |
| Comparative Example 1-6 | A-19 | Dibutyl ether | 100 | 2.70 | 6.1 | 4% | C |
| Comparative Example 1-7 | A-20 | Decane | 100 | 4.61 | 0.2 | 2% | C |

(continued)

| | Processing liquid | Solvent | | Parameters | | Evaluation | |
|---|---|---|---|---|---|---|---|
| | | Name | Percentage | ClogP | ΔH+ΔP | Film reduction in unexposed portions (%) | Grade |
| Comparative Example 1-8 | A-21 | Butyl acetate (n-BA) | 100 | 1.44 | 10.9 | 3% | C |
| Comparative Example 1-9 | A-22 | Hexane | 100 | 2.34 | 0.2 | 2% | C |
| Comparative Example 1-10 | A-23 | Octanol | 100 | 1.9 | 17.7 | 5% | C |
| Comparative Example 1-11 | A-24 | Diethylene glycol monobutyl ether (BDG) | 100 | 0.77 | 16.7 | 7% | C |

From Table 2, it can be understood that when a solvent for which the ClogP value of the solvent is 0.7 or less and the ΔH + ΔP value is 16 or greater is used as a processing liquid, as in the cases of processing liquids A-1 to A-13, the test yields good results. In such cases, the evaluation of film reduction in unexposed portions of the test film was grade A or B throughout.

However, when the solvent had a ClogP value of 0.7 or less but a ΔH + ΔP value less than 16, as in the case of processing liquid A-18, or when the solvent had a ΔH + ΔP value of 16 or greater but a ClogP value greater than 0.7, as in the cases of processing liquids A-14, A-16, A-23, and A-24, the test yielded an evaluation of C in film reduction in unexposed portions of the test film. In addition, when the solvent had a ClogP value greater than 0.7 and a ΔH + ΔP value less than 16, as in the cases of processing liquids A-15, A-17, and A-19 to A-22, the test yielded an evaluation of C in film reduction in unexposed portions of the test film.

[4. Study and Evaluation of Processing Liquids (solvent mixtures of a first solvent and a second solvent)]

The test film described above was developed for 60 seconds using processing liquids B-1 to B-13 specified in Table 3 below, each of which contained a first solvent and a second solvent, and then rinsed for 15 seconds using 2-propanol. Thereafter, the changes in thickness in the exposed portions and the unexposed portions were measured using a film thickness measuring device.

It should be noted that the percentages (by mass) of solvents 1 and 2 in each processing liquid are presented in Table 3.

<Film Reduction in Unexposed Portions>

Focusing on the change in thickness in the unexposed portions of the test film before and after development, film reduction in unexposed portions (= ((film thickness before development - film thickness after development) / film thickness before development) × 100 (%)) was calculated. Then the developability of each processing liquid was evaluated according to the same grading criteria as provided above. The results are presented in Tables 3.

<Evaluation of Selectivity>

Focusing on the changes in thickness in the unexposed portions and exposed portions of the test film after development, the selectivity ratio (= film reduction in unexposed portions/reduction in exposed portions) was calculated. Then the selectivity of each processing liquid was evaluated according to the grading criteria below. The results are presented in Tables 4 to 6.

A (excellent): The selectivity ratio is 20 or greater
B (good): The selectivity ratio is 10 or greater and less than 20
C (poor): The selectivity ratio is less than 10

[Table 3]

| | Processing liquid | Solvent 1 | | Solvent 2 | | Development duration (s) | Evaluation | | | |
|---|---|---|---|---|---|---|---|---|---|---|
| | | Name | Percentage | Name | Percentage | | Film reduction in unexposed portions (%) | Grade | Selectivity ratio | Grade |
| Example 2-1 | B-1 | PGM E | 70 | PGMEA | 30 | 60 s | 100% | A | 23.0 | A |
| Exampl e 2-2 | B-2 | PGM E | 50 | n-BA | 50 | 60 s | 99% | A | 23.0 | A |
| Exampl e 2-3 | B-3 | PGM E | 50 | Hexane | 50 | 60 s | 99% | A | 23.6 | A |
| Exampl e 2-4 | B-4 | PGM E | 50 | Decane | 50 | 60 s | 100% | A | 23.0 | A |
| Exampl e 2-5 | B-5 | PGM E | 50 | t-BuOH | 50 | 60 s | 100% | A | 27.4 | A |
| Exampl e 2-6 | B-6 | PGM E | 50 | Octanol | 50 | 60 s | 100% | A | 21.2 | A |
| Exampl e 2-7 | B-7 | PGM E | 50 | MIBC | 50 | 60 s | 100% | A | 24.5 | A |
| Exampl e 2-8 | B-8 | PGM E | 50 | MIBK | 50 | 60 s | 99% | A | 22.1 | A |
| Exampl e 2-9 | B-9 | PGM E | 50 | BDG | 50 | 60 s | 100% | A | 26.5 | A |
| Exampl e 2-10 | B-10 | PGM E | 50 | 3-Methoxy -3-methyl-1-butanol | 50 | 60 s | 100% | A | 29.6 | A |
| Exampl e 2-11 | B-11 | MeO H | 60 | MIBC | 40 | 60 s | 100% | A | 14.1 | B |
| Exampl e 2-12 | B-12 | MeO H | 55 | MIBC | 45 | 60 s | 99% | A | 87.9 | A |
| Exampl e 2-13 | B-13 | MeO H | 50 | MIBC | 50 | 60 s | 92% | A | 14.6 | B |

From Table 3, it can be understood that even with a processing liquid in which PGME or MeOH, each of which is a first solvent, having a ClogP value of 0.7 or less and a ΔH + ΔP value of 16 or greater, is mixed with a second solvent, which has a ClogP value greater than 0.7 and/or a ΔH + ΔP value less than 16, as in the cases of processing liquids B-1 to B-13, the test yields good results in both grades of film reduction in unexposed portions of the test film and selectivity ratio, provided that a predetermined amount of the first solvent is contained.

It can be, furthermore, understood that as in the cases of processing liquids B-11 to B-13, by adjusting the percentages of the first solvent and the second solvent, the selectivity ratio for film reduction between unexposed portions and exposed portions of the test film can be improved.

[5. Study and Evaluation of Processing Liquids (solvent mixtures of an organic solvent and water)]

<Solvent Mixtures of PGME and Water>

The test film described above was developed for 60 seconds using processing liquids C-1 to C-5, C-8, and C-10 specified in Table 4 below, each of which contained an organic solvent (first solvent) and water, and then rinsed for 15 seconds using 2-propanol. Thereafter, the changes in thickness in the exposed portions and the unexposed portions were measured using a film thickness measuring device.

Likewise, the test film described above was developed for 300 seconds at 23°C using processing liquids C-6, C-7, C-9, and C-11 specified in Table 4 below, and then rinsed for 15 seconds at 23°C using 2-propanol. Thereafter, the changes in thickness in the exposed portions and the unexposed portions were measured using a film thickness measuring device.

It should be noted that the percentages (by mass) of solvents 1 and 2 in each processing liquid are presented in Table 4.

For the evaluation of film reduction in unexposed portions of the test film and selectivity, furthermore, evaluations were made according to the same grading criteria as provided above. The results are presented in Table 4.

[Table 4]

| | Processing liquid | Solvent 1 | | Solvent 2 | | Development duration (s) | Evaluation | | | |
|---|---|---|---|---|---|---|---|---|---|---|
| | | Name | Percentage | Name | Percentage | | Film reduction in unexposed portions (%) | Grade | Selectivity ratio | Grade |
| Example 3-1 | C-1 | PGME | 90 | $H_2O$ | 10 | 60 s | 100% | A | 11.3 | B |
| Example 3-2 | C-2 | PGME | 80 | $H_2O$ | 20 | 60 s | 100% | A | 28.9 | A |
| Example 3-3 | C-3 | PGME | 70 | $H_2O$ | 30 | 60 s | 100% | A | 32.1 | A |
| Example 3-4 | C-4 | PGME | 50 | $H_2O$ | 50 | 60 s | 100% | A | 26.0 | A |
| Example 3-5 | C-5 | PGME | 40 | $H_2O$ | 60 | 60 s | 54% | B | 36.9 | A |
| Example 3-6 | C-6 | PGME | 40 | $H_2O$ | 60 | 300 s | 63% | B | 31.8 | A |
| Example 3-7 | C-7 | PGME | 30 | $H_2O$ | 70 | 300 s | 50% | B | 80.0 | A |
| Comparative Example 3-1 | C-8 | PGME | 20 | $H_2O$ | 80 | 60 s | 15% | C | 7.9 | C |
| Comparative Example 3-2 | C-9 | PGME | 20 | $H_2O$ | 80 | 300 s | 20% | C | 11.3 | B |
| Comparative Example 3-3 | C-10 | PGME | 10 | $H_2O$ | 90 | 60 s | 7% | C | 3.3 | C |
| Comparative Example 3-4 | C-11 | PGME | 10 | $H_2O$ | 90 | 300 s | 10% | C | 1.4 | C |

From Table 4, it can be understood that when water is contained at a concentration of 10% to 70% by mass in addition to PGME, which is a first solvent, having a ClogP value of 0.7 or less and a ΔH + ΔP value of 16 or greater, as in the cases of processing liquids C-1 to C-7, the test yields good results in both grades of film reduction in unexposed portions of the test film and selectivity ratio.

However, when the amount of water in the processing liquid was 80% or more, as in the cases of processing liquids C-8 to C-11, the result of the grading of film reduction in unexposed portions of the test film was C. With processing liquid C-9, the test yielded a grade of B in selectivity ratio between unexposed portions and exposed portions of the test film. However, with processing liquids C-8, C-10, and C-11, the test resulted in a selectivity ratio grade of C.

<Solvent Mixtures of a First Solvent Other Than PGME and Water>

The test film described above was developed for 60 seconds using processing liquids D-1 to D-11 specified in Table 5 below, each of which contained a first solvent and water, and then rinsed for 15 seconds using 2-propanol. Thereafter, the changes in thickness in the exposed portions and the unexposed portions were measured using a film thickness measuring device.

It should be noted that the percentages (by mass) of solvents 1 and 2 in each processing liquid are presented in Table 5.

For the evaluation of film reduction in unexposed portions of the test film and selectivity, furthermore, evaluations were made according to the same grading criteria as provided above. The results are presented in Table 5.

[Table 5]

| | Processin g liquid | Solvent 1 | | Solvent 2 | | Developme nt duration (s) | Evaluation | | | |
|---|---|---|---|---|---|---|---|---|---|---|
| | | Name | Percentag e | Nam e | Percentag e | | **Film** reduction in unexpose d portions (%) | Grad e | Selectivit y ratio | Grad e |
| Exampl e 4-1 | D-1 | MeOH | 80 | $H_2O$ | 20 | 60 s | 100% | A | 10.8 | B |
| Exampl e 4-2 | D-2 | MeOH | 70 | $H_2O$ | 30 | 60 s | 100% | A | 16.2 | B |
| Exampl e 4-3 | D-3 | MeOH | 60 | $H_2O$ | 40 | 60 s | 100% | A | 15.1 | B |
| Exampl e 4-4 | D-4 | MeOH | 50 | $H_2O$ | 50 | 60 s | 98% | A | 226.7 | A |
| Exampl e 4-5 | D-5 | MeOH | 40 | $H_2O$ | 60 | 60 s | 55% | B | 64.4 | A |
| Exampl e 4-6 | D-6 | Methyl 2-hydroxyisobutyra te | 50 | $H_2O$ | 50 | 60 s | 99% | A | 19.7 | B |
| Exampl e 4-7 | D-7 | EtOH | 50 | $H_2O$ | 50 | 60 s | 100% | A | 21.0 | A |
| Exampl e 4-8 | D-8 | Hydroxyacetone | 50 | $H_2O$ | 50 | 60 s | 100% | A | 20.2 | A |
| Exampl e 4-9 | D-9 | 4-Hydroxy-2-butanone | 50 | $H_2O$ | 50 | 60 s | 100% | A | 28.2 | A |
| Exampl e 4-10 | D-10 | Diacetone alcohol | 50 | $H_2O$ | 50 | 60 s | 100% | A | 18.5 | B |
| Exampl e 4-11 | D-11 | Ethyl lactate (EL) | 50 | $H_2O$ | 50 | 60 s | 100% | A | 16.5 | B |

From Table 5, it can be understood that when water is additionally contained in addition to a first solvent, which has a ClogP value of 0.7 or less and a ΔH + ΔP value of 16 or greater, as in the cases of processing liquids D-1 to D-11, the test yields good results in both grades of film reduction in unexposed portions of the test film and selectivity ratio.

It can be, furthermore, understood that as in the cases of processing liquids D-1 to D-5, by adjusting the percentages of the organic solvent (first solvent) and water, the selectivity ratio for film reduction between unexposed portions and exposed portions of the test film can be improved.

<Solvent Mixtures of an Organic Solvent (first solvent and second solvent) and Water>

The test film described above was developed for 60 seconds using processing liquids E-1 to E-5 specified in Table 6 below, each of which contained an organic solvent (a first solvent and a second solvent) and water, and then rinsed for 15 seconds using 2-propanol. Thereafter, the changes in thickness in the exposed portions and the unexposed portions were measured using a film thickness measuring device.

It should be noted that the percentages (by mass) of solvents 1 to 3 in each processing liquid are presented in Table 6.

For the evaluation of film reduction in unexposed portions of the test film and selectivity, furthermore, evaluations were made according to the same grading criteria as provided above. The results are presented in Table 6.

[Table 6]

| | Processing liquid | Solvent 1 | | Solvent 2 | | Solvent 3 | | Development duration (s) | Evaluation | | | |
|---|---|---|---|---|---|---|---|---|---|---|---|---|
| | | Name | Percentage | Name | Percentage | Name | Percentage | | Film reduction in unexposed portions (%) | Grade | Selectivity ratio | Grade |
| Example 5-1 | E-1 | PGME | 70 | PGMEA | 30 | $H_2O$ | 0 | 60 s | 100% | A | 23.0 | A |
| Example 5-2 | E-2 | PGME | 49 | PGMEA | 21 | $H_2O$ | 30 | 60 s | 100% | A | 26.2 | A |
| Example 5-3 | E-3 | PGME | 35 | PGMEA | 15 | $H_2O$ | 50 | 60 s | 100% | A | 27.3 | A |
| Example 5-4 | E-4 | PGME | 21 | PGMEA | 9 | $H_2O$ | 70 | 60 s | 100% | A | 17.2 | B |
| Comparative Example 5-1 | E-5 | PGME | 14 | PGMEA | 6 | $H_2O$ | 80 | 60 s | 38% | C | 25.6 | A |

From Table 6, it can be understood that when a processing liquid that contains an organic solvent containing a first solvent, which has a ClogP value of 0.7 or less and a $\Delta H + \Delta P$ value of 16 or greater, at a concentration of 70% by mass and a second solvent, which does not, at a concentration of 30% by mass and that also contains water at a concentration of 0% to 70% by mass is used, as in the cases of processing liquids E-1 to E-4, the test yields good results in both grades of film reduction in unexposed portions of the test film and selectivity ratio.

However, when the amount of water in the processing liquid was 80%, as in the case of processing liquid E-5, the result of the grading of film reduction in unexposed portions of the test film was C. In the grading of selectivity ratio between unexposed portions and exposed portions of the test film for processing liquid E-5, by contrast, the test yielded a good result of A.

## Claims

**1.** A pattern forming method comprising a step of exposing a metal compound-containing film and a step of processing the exposed metal compound-containing film using a processing liquid, wherein

the processing liquid contains an organic solvent,
the organic solvent contains one or more first solvents for each of which $\text{ClogP} \leq 0.7$ and $\Delta H + \Delta P \geq 16$, and
an amount of the first solvents is 30% by mass or more relative to 100% by mass of the organic solvent.

**2.** A pattern forming method comprising a step of forming a metal compound-containing film using a metal compound-containing film forming composition, a step of exposing the metal compound-containing film, and a step of processing the exposed metal compound-containing film using a processing liquid, wherein

the processing liquid contains an organic solvent,
the organic solvent contains one or more first solvents for each of which $\text{ClogP} \leq 0.7$ and $\Delta H + \Delta P \geq 16$, and
an amount of the first solvents is 30% by mass or more relative to 100% by mass of the organic solvent.

**3.** The pattern forming method according to claim 1, wherein

the organic solvent further contains one or more second solvents different from the first solvents, and
an amount of the second solvents is 1% to 70% by mass relative to 100% by mass of the organic solvent.

**4.** The pattern forming method according to claim 3, wherein
the second solvents are one or more solvents different from the first solvents and selected from the group consisting of alcohol-based solvents containing three or more carbon atoms, ester-based solvents containing three or fewer oxygen atoms, and ketone-based solvents that do not contain two or more oxygen atoms.

**5.** The pattern forming method according to claim 3, wherein
the second solvents are one or more solvents for each of which $\text{ClogP} > 0.7$ and $\Delta H + \Delta P \leq 25$ or, alternatively, $\text{ClogP} \geq 0.35$ and $\Delta H + \Delta P < 16$.

**6.** The pattern forming method according to claim 3, wherein
the second solvents are one or more solvents selected from the group consisting of propylene glycol monomethyl ether acetate (PGMEA), ethyl acetate, butyl acetate, 3-methoxy-3-methyl-1-butanol, 4-methyl-2-pentanol (MIBC), methyl isobutyl ketone (MIBK), benzyl alcohol, t-butyl alcohol, octanol, hexane, decane, and diethylene glycol monobutyl ether (BDG).

**7.** The pattern forming method according to claim 1, wherein
the processing liquid further contains water.

**8.** The pattern forming method according to claim 7, wherein
an amount of the water is 1% to 75% by mass relative to 100% by mass of the processing liquid.

**9.** The pattern forming method according to claim 1, wherein
the metal compound-containing film is a metal compound-containing film containing a metal element of group 3 to group 7.

**10.** The pattern forming method according to claim 1, wherein the metal compound is a polyoxometalate.

**11.** The pattern forming method according to claim 10, wherein the polyoxometalate is a polyoxomolybdate, a polyoxotungstate, a polyoxovanadate, a polyoxoniobate, or a polyoxotantalate.

**12.** The pattern forming method according to claim 10, wherein the polyoxometalate is an onium salt.

**13.** The pattern forming method according to claim 12, wherein the onium salt is an ammonium salt, a sulfonium salt, or an iodonium salt.

**14.** The pattern forming method according to claim 1, wherein the exposure step is a step of exposing the metal compound-containing film using EUV or an electron beam.

**15.** A processing liquid for a metal compound-containing film,

the processing liquid comprising an organic solvent, wherein
the organic solvent contains one or more first solvents for each of which $ClogP \leq 0.7$ and $\Delta H + \Delta P \geq 16$, and an amount of the first solvents is 30% by mass or more relative to 100% by mass of the organic solvent.

**16.** The processing liquid according to claim 15 for a metal compound-containing film, wherein

the organic solvent further contains one or more second solvents different from the first solvents, and
an amount of the second solvents is 1% to 70% by mass relative to 100% by mass of the organic solvent.

**17.** The processing liquid according to claim 16 for a metal compound-containing film, wherein the second solvents are one or more solvents different from the first solvents and selected from the group consisting of alcohol-based solvents containing three or more carbon atoms, ester-based solvents containing three or fewer oxygen atoms, and ketonebased solvents that do not contain two or more oxygen atoms.

**18.** The processing liquid according to claim 16 for a metal compound-containing film, wherein the second solvents are one or more solvents for each of which $ClogP > 0.7$ and $\Delta H + \Delta P \leq 25$ or, alternatively, $ClogP \geq 0.35$ and $\Delta H + \Delta P < 16$.

**19.** The processing liquid according to claim 15 for a metal compound-containing film, the processing liquid further comprising water.

**20.** The processing liquid according to any one of claims 15 to 19 for a metal compound-containing film, wherein the processing liquid is a processing liquid for a polyoxometalate-containing film.

## INTERNATIONAL SEARCH REPORT

International application No. **PCT/JP2024/018746**

**A. CLASSIFICATION OF SUBJECT MATTER**

***G03F 7/32***(2006.01)i; ***G03F 7/004***(2006.01)i; ***G03F 7/20***(2006.01)i
FI: G03F7/32; G03F7/004; G03F7/004 531; G03F7/20 521

According to International Patent Classification (IPC) or to both national classification and IPC

**B. FIELDS SEARCHED**

Minimum documentation searched (classification system followed by classification symbols)

G03F7/32; G03F7/004; G03F7/20

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2023-013561 A (SAMSUNG ELECTRONICS CO., LTD.) 26 January 2023 (2023-01-26) claims, examples | 1-20 |
| X | JP 05-501164 A (BOARD OF REGENTS, THE UNIVERSITY OF TEXAS SYSTEM) 04 March 1993 (1993-03-04) claims, examples | 1-2, 7-15, 19-20 |
| X | WO 2022/209950 A1 (NIPPON SHOKUBAI CO., LTD.) 06 October 2022 (2022-10-06) claims, examples | 1-3, 7-8, 10, 14-16, 19-20 |
| X | JP 2021-532406 A (YOUNG CHANG CHEMICAL CO., LTD.) 25 November 2021 (2021-11-25) claims, examples | 1-6, 9, 14-18, 20 |
| X | WO 2022/016124 A1 (LAM RESEARCH CORPORATION) 20 January 2022 (2022-01-20) claims | 1-2, 9, 14-15, 20 |

☑ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **23 July 2024** | **06 August 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**

International application No.
**PCT/JP2024/018746**

**C. DOCUMENTS CONSIDERED TO BE RELEVANT**

| Category* | Citation of document, with indication, where appropriate, of the relevant passages | Relevant to claim No. |
|---|---|---|
| P, X | JP 2024-007318 A (SAMSUNG SDI CO., LTD.) 18 January 2024 (2024-01-18) examples | 1-6, 14-18, 20 |

Form PCT/ISA/210 (second sheet) (July 2022)

**INTERNATIONAL SEARCH REPORT**
**Information on patent family members**

International application No.
**PCT/JP2024/018746**

| Patent document cited in search report | Publication date (day/month/year) | Patent family member(s) | Publication date (day/month/year) |
|---|---|---|---|
| JP 2023-013561 A | 26 January 2023 | US 2023/0022002 A1<br>claims, examples<br>KR 10-2023-0012977 A | |
| JP 05-501164 A | 04 March 1993 | US 5178989 A<br>claims, examples | |
| WO 2022/209950 A1 | 06 October 2022 | KR 10-2024-0009394 A<br>TW 202248202 A | |
| JP 2021-532406 A | 25 November 2021 | US 2021/0333709 A1<br>claims, examples<br>WO 2020/032398 A1<br>EP 3835870 A1<br>TW 202007681 A<br>CN 112543890 A<br>KR 10-1910157 B1 | |
| WO 2022/016124 A1 | 20 January 2022 | JP 2023-534961 A<br>US 2023/0288798 A1<br>CN 116134381 A<br>KR 10-2023-0051769 A<br>TW 202217446 A | |
| JP 2024-007318 A | 18 January 2024 | US 2024/0019784 A1<br>examples<br>KR 10-2024-0005483 A<br>CN 117348341 A | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 11392028 B
- US 2021026241 A
- JP 63113452 A
- JP 59154089 A
- JP 58180400 A